# EUROPEAN PATENT APPLICATION

(11) **EP 3 116 021 A1**
(43) Date of publication of application: **11.01.2017**
(21) Application number: 15175694.7
(22) Date of filing: 07.07.2015
(51) Int. Cl.: H01L 23/473

(54) **POWER SEMICONDUCTOR MODULE**

(71) Applicant: ABB Technology AG, 8050 Zürich (CH)
(72) Inventor: Kearney, Daniel, 8004 Zürich (CH); Mohn, Fabian, 5408 Ennetbaden (CH); Schuderer, Jürgen, 8047 Zürich (CH); Traub, Felix, 4310 Rheinfelden (CH); Torresin, Daniele, 5413 Birmenstorf (CH)
(74) Representative: ABB Patent Attorneys

(57) **Abstract**

The present invention relates to a temperature controlling element for controlling the temperature of a plurality of power semiconductor devices in a power semiconductor module, the temperature controlling element comprising a layer arrangement with a plurality of layers, wherein the layer arrangement comprises
- a center layer (10),
- a first outer layer (12) and a second outer layer (14) each being arranged in a direction normal to the center layer (10), wherein the first outer layer (12) and the second outer layer (14) are located at opposite sides of the center layer (10) in a direction normal to the center layer (10), and
- a first intermediate layer (16) and a second intermediate layer (18), wherein the first intermediate layer (16) is located between the center layer (10) and the first outer layer (12) in a direction normal to the center layer (10), and wherein the second intermediate layer (18) is located between the center layer (10) and the second outer layer (14) in a direction normal to the center layer (10);
wherein
- the center layer (10) comprises an inlet (20) for guiding cooling fluid into the layer arrangement and an outlet (22) for guiding cooling fluid out of the layer arrangement, wherein the center layer (10) is further adapted for guiding cooling fluid from the inlet (20) into the first intermediate layer (16) and into the second intermediate layer (18) and back from the first intermediate layer (16) and from the second intermediate layer (18) to the outlet (22), wherein
- the first intermediate layer (16) is adapted for guiding cooling fluid from the center layer (10) to the first outer layer (12) and wherein the second intermediate layer (18) is adapted for guiding cooling fluid from the center layer (10) to the second outer layer (18), and wherein
- the first outer layer (12) is adapted for guiding cooling fluid from the first intermediate layer (16) back to the first intermediate layer (16) and wherein the second outer layer (18) is adapted for guiding cooling fluid from the second intermediate layer (18) back to the second intermediate layer (18). To summarize, such a temperature controlling element provides an integrated microfluidic jet cooler which permits targeted cooling of power electronic components - primarily semiconductor chips - in an ultra-compact module in order to achieve very high heat transfer coefficients.

## Description

### Technical Field

The Invention relates to a cooling element for a power semiconductor module and to a power semiconductor module comprising such a cooling element. In particular, the invention relates to a cooling element and a power semiconductor module showing an effective thermal management for a plurality of power semiconductor devices.

### Background Art

Power semiconductor modules are known in the art and used in different areas of application. Important for power semiconductor modules is to provide an efficient thermal management as power semiconductor devices being present in said power semiconductor modules often require effective cooling.

In fact, existing power semiconductor modules and their performance are sometimes thermally limited. In other words, if cooling of the power semiconductor devices provided therein can be improved, more current can be passed through the devices. Since the semiconductor device is usually the most expensive part of a module, such as of a converter, it is appealing to exploit its full potential by improving the cooling and reducing the thermal resistance of the package design. However, simply integrating more effective cooling into the package is often not sufficient and a more targeted approached may be required to manage package hot spots.

Regarding cooling of power semiconductor modules, or power semiconductor devices, respectively, document US 8,659,896 B2 describes a cooling apparatus for a power electronics system which includes a jet plate, a target plate, a plurality of fluid collection passageways, and a fluid outlet. The jet plate includes an array of impingement jets having a jet body and an impingement jet channel. The target plate includes an array of microchannel cells having a plurality of radially-extending wavy-fin microchannels. The coolant fluid is directed toward an impingement location through the array of impingement jets and travels through the wavy-fin microchannels. The plurality of fluid collection passageways are arranged in a grid pattern such that the coolant fluid exits the wavy-fin microchannels and flows into the plurality of fluid passageways. The coolant fluid exits the cooling apparatus through the fluid outlet. The cooling apparatus may be incorporated into a power electronics module having a power electronics device to cool the power electronics device.

Document US 2011/0042041 A1 describes an apparatus for dissipating heat. First jets are streamed along a heat dissipation surface in a first direction and are spaced apart from one another. Second jets are streamed along the heat dissipation surface in a second direction at least substantially opposite the first direction and spaced apart from one another. Coolant used to provide the first jets and the second jets is exited away from the heat dissipation surface. The first jets and the second jets are offset from one another in a transverse direction with respect to the first direction and the second direction, and the first jets and the second jets pass side-by-side with respect to one another.

According to document US 8,391,008 B2, a power electronics module includes a frame, a jet impingement cooler assembly, and a power electronics assembly. The frame includes a first surface, a second surface, a power electronics cavity within the first surface of the frame, a fluid inlet reservoir, and a fluid outlet reservoir. The fluid inlet and outlet reservoirs extend between the first surface of the frame and the second surface of the frame. The fluid inlet reservoir and the fluid outlet reservoir are configured to be fluidly coupled to one or more additional modular power electronics devices. The jet impingement assembly is sealed within the frame and fluidly coupled to the fluid inlet reservoir and the fluid outlet reservoir. The power electronics assembly includes at least one power electronics component, which is positioned within the power electronics cavity, and which is thermally coupled to the jet impingement cooler assembly. Power electronic module assemblies are also disclosed.

C.M. Johnson et al., Compact Double-Side Liquid Impingement-Cooled Integrated Power Electronic Module, Proceedings of the 19th International Symposium on Power Semiconductor Devices & ICs, May 27-30, 2007, Jeju, Korea, describes an integrated power electronic module (IPEM), which provides a double side cooling of embedded dies. This is realized by clamping three power modules between two heat-exchangers.

Michael M. Ohadi, Advanced Air cooling technologies, ARPA-e Alternative Power plant cooling workshop, May 12-2014, further discloses air cooling heat exchangers.

Known from Schweitzer under its name "p2 pack" is as well to provide power modules combined with PCB technology.

Regarding the solutions of the prior art, there is, however, still potential for improvements for power semiconductor modules especially regarding their thermal management systems.

### Summary of invention

It is therefore an object of the present invention to provide an improved power semiconductor module which shall obviate at least one of the disadvantages known in the art.

In particular, it is an object of the present invention to provide a power semiconductor module which provides the possibility of an effective thermal management of a plurality of power semiconductor devices.

These objects are at least partly achieved by a temperature controlling element according to claim 1. These objects are further at least partly achieved by a power semiconductor module according to claim 11. Preferred embodiments of the present invention are defined in the dependent claims.

The present invention relates to a temperature controlling element for controlling the temperature of a plurality of power semiconductor devices in a power semiconductor module, the temperature controlling element comprising a layer arrangement with a plurality of layers which may be arranged parallel to each other, wherein the layer arrangement comprises
- a center layer,
- a first outer layer and a second outer layer each being arranged in a direction normal to the center layer, wherein the first outer layer and the second outer layer are located at opposite sides of the center layer in a direction normal to the center layer, and
- a first and a second intermediate layer, wherein the first intermediate layer is located between the center layer and the first outer layer in a direction normal to the center layer, and wherein the second intermediate layer is located between the center layer and the second outer layer in a direction normal to the center layer;
wherein
- the center layer comprises an inlet for guiding cooling fluid into the layer arrangement and an outlet for guiding cooling fluid out of the layer arrangement, wherein the center layer is further adapted for guiding cooling fluid from the inlet into the first intermediate layer and into the second intermediate layer and back from the first intermediate layer and from the second intermediate layer to the outlet, wherein
- the first intermediate layer is adapted for guiding cooling fluid from the center layer to the first outer layer and wherein the second intermediate layer is adapted for guiding cooling fluid from the center layer to the second outer layer, wherein
- the first outer layer is adapted for guiding cooling fluid from the first intermediate layer back to the first intermediate layer and wherein the second outer layer is adapted for guiding cooling fluid from the second intermediate layer back to the second intermediate layer.

Such a temperature controlling element for a power semiconductor device allows effectively controlling the temperature of a plurality of power semiconductor devices, even in case a large number of power semiconductor devices is provided.

In detail, a temperature controlling element as described is especially provided for being arranged in a power semiconductor module. As such, it is adapted for controlling the temperature of one or more power semiconductor devices. In particular, the temperature controlling element is adapted for controlling the temperature of a plurality of power semiconductor devices like it will be described down below.

Regarding the power semiconductor devices, the latter may comprise active devices, such as a transistor, such as a switch, and/or a diode, or it may comprise passive devices, such as a capacitor, a filter, or an inductive element, for example.

Regarding controlling the temperature of power semiconductor devices, temperature controlling may generally comprise cooling such devices. However, the present invention is not strictly limited to cooling purposes. It is generally as well possible to heat power semiconductor devices, in case it is required. Therefore, in case the term cooling is used for describing the arrangement and working of the temperature controlling element according to the present invention, the latter may generally as well be performed in a comparable manner by a heating process.

A temperature controlling element as described is arranged as it will be described in detail down below.

In detail, the temperature controlling element as described comprises a layer arrangement with a plurality of layers. The layers may advantageously be arranged parallel to each other. According to this, different layers are provided, which each are aligned in a plane, wherein the different planes and thus the layers are aligned advantageously parallel to each other. The different layers may have different purposes and may be formed differently from each other. With this regard, it may be provided that the layers are formed as different parts, such as one part per layer, or the layer arrangement may be formed as one part and the term layer may thus solely be understood in a functional manner.

Regarding the layer arrangement, the latter comprises a center layer, at least two outer layers and at least two intermediate layers.

The first outer layer and the second outer layer are arranged in a direction normal to the center layer, wherein the first outer layer and the second outer layer are located at opposite sides of the center layer in a direction normal to the center layer.

Further, the first intermediate layer is located between the center layer and the first outer layer in a direction normal to the center layer, and the second intermediate layer is located between the center layer and the second outer layer in a direction normal to the center layer.

Thus, in other words, on both sides of the center layer in a direction normal to the center layer, each an intermediate layer is provided between the center layer and a respective outer layer.

Therefore, a layer sequence may be as follows in the direction normal to the center layer: first outer layer - first intermediate layer - center layer - second intermediate layer - second outer layer. However, it is not excluded from the present invention that further layers are comprised by said layer arrangement. Apart from that regarding both sides of the center layer normal to the center layer, both sides may be formed correspondingly and thus with the same parts, or the respective sides may be formed different from each other. The center layer is thus particularly provided in the exact middle part of the layer arrangement in case both sides are formed the same or it may be not the exact spatial middle part in case the two sides are formed differently.

The center layer comprises an inlet for guiding cooling fluid into the layer arrangement and an outlet for guiding cooling fluid out of the layer arrangement. The inlet as well as the outlet may be arranged such, that the cooling fluid flows into the inlet and out of the outlet in a direction of the plane of the center layer.

Therefore, the center layer is connectable to a pathway which guides cooling fluid to the temperature controlling element and thus the layer arrangement and the center layer is connectable to a pathway which guides cooling fluid away from the layer arrangement and thus from the temperature controlling element. Inside the layer arrangement, the cooling fluid may be guided coming from the inlet at least partly in a direction of the plane of the center layer in the center layer, it may then be guided at least partly in a direction normal to the plane of the center layer through the intermediate layer and may then be guided at least partly in a direction of the plane of the outer layer in the respective outer layer, i.e. the first or the second outer layer depending on the side of the layer arrangement. Correspondingly, the cooling fluid may be guided from the respective outer layer to the outlet in that it flows at least partly in a direction normal to the plane of the center layer through the intermediate layer and further at least partly in a direction in the plane of the center layer through the center layer to the outlet. However, the invention is not strictly limited to the above flowing directions as it may additionally flow in angles referring the direction in of the respective layer planes as well as referring to the direction normal thereto.

The temperature controlling element is thus based on a fluid temperature controlling system which uses a cooling fluid. Therefore, the layer arrangement generally comprises a pathway for the cooling fluid which guides the latter from the inlet through the layer arrangement and to the outlet. In particular, the temperature controlling element is a jet temperature controlling element, or a jet impingement temperature controlling element, respectively.

The cooling fluid may be a liquid, a gas, or even a mixture of a fluid and a gas. For example, the cooling fluid may comprise water. Although the term cooling fluid is generally used, it is obvious for the person skilled in the art that the cooling fluid may also serve for heating purposes, depending on the temperature of the cooling fluid which enters the inlet, like it is described above.

The center layer is thus adapted for guiding cooling fluid from the inlet into the first intermediate layer and into the second intermediate layer and, like it will be described down below, back from the first intermediate layer and from the second intermediate layer to the outlet.

The first intermediate layer is adapted for guiding cooling fluid from the center layer to the first outer layer. Correspondingly, the second intermediate layer is adapted for guiding cooling fluid from the center layer to the second outer layer. Therefore, it is advantageously provided that the cooling fluid passes the intermediate layer in a direction essentially normal to the plane of the intermediate layer. Essentially normal according to the present invention shall particularly mean that the cooling fluid at least partly flows in a direction which is perpendicular to the plane of the intermediate layer, or in an angle of ≥ 60° to ≤ 120°, particularly in an angle of ≥ 75° to ≤ 105°, for example in an angle of ≥ 85° to ≤ 95°, referring to the plane of the intermediate layer.

It may thereby be provided that at least one, preferably both intermediate layers serve for distributing the cooling fluid such, that it reaches a large surface of the outer layers.

The intermediate layer may for example comprise a plurality of orifices, through which the cooling fluid may be guided. In case cooling fluid is guided through these orifices, the orifices may create a jet when a fluid flow passes through the orifices and accelerates. This may allow that the cooling fluid in a defined manner is guided to the outer layers. Therefore, the arrangement of the intermediate layer may serve that the cooling fluid which comes from the center layer is distributed in a large amount in the plane of the outer layer when it enters the outer layer. For example, orifices may be present in an amount of ≥ 1 to ≤ 100 having diameters in the range of ≥ 10µm to ≤5mm, such as ≥ 25µm to ≤1 mm, wherein the number and size may be adapted to the respective application.

Regarding the outer layers, the first outer layer is adapted for guiding cooling fluid from the intermediate layer back to the first intermediate layer and the second outer layer is adapted for guiding cooling fluid from the intermediate layer back to the second intermediate layer. In other words, the outer layer serves for receiving the cooling fluid, advantageously collecting the latter and guiding it back to the intermediate layer, from which the cooling fluid is guided to the center layer and particularly to the outlet.

Therefore, it may be provided that the at least one and preferably both outer layers are adapted such, that the cooling fluid is guided at least partly in the plane of the outer layer.

In general, the outer layer is that layer, which is the most active temperature controlling layer and may thus transfer or receive heat to or from the device to be cooled or to be heated. Therefore, additionally to the arrangement of the intermediate layers, one or both outer layers may have a structure for guiding the cooling fluid such, that it reaches a large portion of said outer layer in the plane of the outer layer. This may result in an especially effective temperature controlling effect, such as cooling effect.

A temperature controlling element for a power semiconductor device as described above may provide significant advantages over solutions according to the prior art.

In fact, a temperature controlling element as described has the advantage that by providing the first and the second outer layer and thus two elements which are advantageously located at opposite sides of the layer arrangement and thus in particular of the temperature controlling element, the temperature controlling element may have two sides which have substantially the same temperature controlling effect. With this regard, it becomes possible to not only cool one arrangement of power semiconductor devices, but the temperature controlling element may provide the possibility to control the temperature of two arrangements of power semiconductor devices which are located at opposite sides of the layer arrangement at the same time.

Therefore, the temperature controlling element may allow controlling the temperature of a very large amount of power semiconductor devices at the same time and with a homogeneous temperature controlling effect. This allows a very efficient thermal management of a power semiconductor module due to a double sided cooling, for example. Therefore, it is not required to provide two temperature controlling elements for controlling the temperature of two die arrangements, but only one element like described above is sufficient which significantly reduces costs of a power semiconductor module being equipped with such a temperature controlling element.

Such an effective thermal management may be especially useful in case power semiconductor devices are used which are based on wide bandgap semiconductors. In fact, lower specific on-resistance and switching energy of silicon carbide-based semiconductors, for example, can allow operation at significantly improved efficiency. However, due to the high specific costs of wide bandgap semiconductor chips, such as silicon carbide chips, these power devices are typically much smaller than conventional devices, such as silicon-based devices, in the same voltage class. Therefore, to allow for a cost and performance optimized application, power module design must be suitable to handle high levels of local power & loss densities especially for a large amount of power semiconductor devices.

Due to the shrunken die size and general miniaturization, improvement of heat spreading and reduction of thermal resistances is a key aspect for wide bandgap power modules being based on wide bandgap semiconductors. However, increasing heat spreading increases the thermal resistance and the footprint area of the module. Therefore, having an improved thermal management significantly improves the realization of power modules based on power semiconductor devices and especially of wide bandgap semiconductor based devices. In fact, chip stacking is allowed with only one inlet port and one outlet port for the cooling fluid which simplifies the thermal management system.

The temperature controlling element as described allows a greater density of heat dissipating components to be placed closer together using a unique targeted jet impingement design.

With this regard, it may be further advantageous, that each chip may be locally cooled, for example, independently with the same inlet coolant temperature. This ensures an improved thermal management for each chip and thus better current sharing in the device. Such an effect cannot or only hardly be achieved in a comparable effective manner by using microchannels such as realized in prior art solutions, as the coolant will change its temperature such as heat up as it traverses the module.

The concept is thus adaptable to allow multiple cooling of chip sets having a very homogeneous temperature controlling effect which may reduce or avoid problems regarding local temperature hotspots. In fact the temperature controlling element allows a very homogeneous value of thermal resistance (Rₜₕ) which in turn enables cooling a plurality of paralleled power devices such as UHV bipolar devices.

Further, the temperature controlling element as describes allows an improved adaptability as the cooling or heating performance of every position of the outer layers and thus of different devices can easily be varied by simply varying the fluid pathways in the layer arrangement such as of the orifice diameter and number of orifices in the intermediate layers such as in the jet array which can reduce or enlarge the jet velocity and hence cooling performance, for example. This may further be allowed especially easily in case each layer is formed as one single part. With this regard, the cooling element may be formed as a modular arrangement from which single layers may be exchanged thereby adapting the layer arrangement and the cooling element.

This may be beneficial, for example, when several active devices are placed together with unique losses. This optimization of fluid pathways can additionally serve for reducing the overall pressure drop across the module focusing the maximum pressure drop only where is most needed above the chips.

A further advantage of the temperature controlling element like described may thus be seen in that it may work with minimal pressure drop due to an easy optimization of the fluid pathways. This allows reduced overall pumping cost and the main channels can be increased in diameter. This may be further realized due to the fact that cooling may be applied where it is required most. This is a pertinent advantage over prior art solutions which often do not consider the efficient design of the return outgoing fluid flow.

Integrated temperature controlling like it is possible by the present temperature controlling element further may enable a compact module design with an independent cooling path with an electrical commutation loop. This also enables new 3D power electronic architectures where active and passive components can be placed closer together thereby reducing footprint area, further allowing the inductive loop increasing switching speed ad well as module performance.

High local heat transfer coefficients, such as in an exemplary manner of approximately 50kW/m²K for targeted surfaces with high heat flux with potential heat removal of exemplarily 500W/cm² may be reached, which shows an efficient thermal management.

Apart from the very effective thermal management, a temperature controlling element as described may be manufactured very easily and cost-saving.

The layer structure as described in detail above may for example comprise, or consist of five layers. With this regard, the used intermediate layers may be formed identically on both sides and/or the outer layers on both sides of the center layer may as well be formed identically. This may reduce costs as the amount of different parts may be reduced. Further, a modular arrangement as described before may be realized.

Further, the element, or the layer structure, respectively, may be formed with minimal material costs due to the formation having low volume and thus a light weight design.

Apart from that, the different layers each may have a planar form which further improves the fixation of the different layers. Each layer can be fabricated with traditional routing or drilling technique especially in case it is formed in a planar manner. With this regard, the different layers can be brazed, sintered or mechanically coupled together to form a sandwich structure. Such a structure may be very compact and may have a height in the range of ≥ 35mm to ≤ 200mm, such as ≥ 50mm to ≤ 120mm, for example of ≥ 55mm to ≤ 100mm, as an example of approximately 71 mm. This shows that the respective layers and thus the whole layer arrangement may form an efficient cooling device for a plurality of power semiconductor devices which may be formed very compact and does not require large space.

With regard to the center layer, this layer may be formed as a manifold layer with divides the flow of cooling fluid into the first and the second intermediate layer and thus, for example, in the top and bottom layers and guides the flow to the associated intermediate layer. This can be custom machined with a standard routing process to guide the flow to the arrays depending on their position.

The intermediate layers may contain orifices making the jets which impinge to the respective outer layers so that the intermediate layers may be equipped with a jet array. Such layers may be formed by routing and standard drilling.

The outer layers may be metallic layers and may be directly or indirectly connected to power semiconductor devices and may have large contact to both the semiconductor devices as well as to the cooling fluid so that an effective thermal effect of both outer layers as well as an effective thermal management of the temperature controlling element may be provided. Specifically, integrating the temperature controlling element in the package and closer to the power semiconductor devices may be possible eliminating the various thermal interfaces and thus improving thermal management.

An advantageous feature of the outer layers may comprise flow vane guides which collect coolant from the individual jet impingement zones and return to the central outlet port with minimal pressure drop, like it is described in detail down below.

Targeted cooling may further reduce heat spreading requirements which in conventional solutions may consist of metallic spreader plates. This further shows that the manufacturing of a power semiconductor module may be improved when using a temperature controlling element according to the invention.

An application of the temperature controlling element and of a power semiconductor module equipped therewith may be, for example, in mobile applications. For example, such a module may be used as drive circuit for a high power application, such as an electric motor drive circuit of a hybrid electric vehicle or an electric vehicle. This may be especially advantageous as the temperature controlling element works essentially gravity independent so that even for mobile applications no performance restrictions are to be expected during a ride.

To summarize, this invention provides an integrated microfluidic jet cooler which permits targeted cooling of power electronic components - primarily semiconductor chips - in an ultra-compact module in order to achieve very high heat transfer coefficients.

According to an embodiment, the first intermediate layer comprises at least one inlet fluid flow path for guiding cooling fluid from the center layer to the first outer layer and at least one outlet fluid flow path for guiding cooling fluid from the first outer layer to the center layer, wherein the first outer layer is adapted for guiding cooling fluid from the inlet fluid flow path to the outlet fluid flow path. According to this embodiment, the flow of cooling fluid can be guided to the outer layers and thus to the main effective elements in a defined manner. This may be specially the truth in case the inlet fluid path and the outlet fluid path are separated from one another. With this regard, the temperature controlling efficiency may be adapted especially effectively, as the geometry as well as the position of the respective flow paths may be adapted to provide an especially low pressure drop and it may further be adapted to the interaction with the active surface of the outer layers. Therefore, according to this embodiment, an especially effective thermal management may be achieved.

According to a further embodiment, at least one, advantageously a plurality of inlet fluid flow paths is provided being positioned at an outer portion of the first intermediate layer in the plane of the first intermediate layer and at least one outlet fluid flow path is provided being located at an inner portion in the plane of the first intermediate layer. Preferably, the first as well as the second intermediate layer is arranged as described before. Regarding the inner portion and the outer portion, it may be provided that these expressions relate to each other or, in other words, that the outer portion at least partly encloses, or surrounds, the inner portion relating to the plane of the intermediate layer. The inner portion may be that portion which is located in the center region in the plane of the respective intermediate layer. According to this embodiment, the flow resistance may be especially low as the inlet fluid paths may guide the cooling fluid in a large amount and to a large area, the area lying in the plane of the outer layer, to said outer layer, at which the cooling fluid is guided to the inner portion for guiding it back to the outlet. This may allow the fluid paths to be located in an especially easy manner as in the plane of the intermediate layer an outer region may be solely serve for guiding the cooling fluid in one direction whereas the inner portion may solely serve for guiding the cooling fluid in the opposite direction. Therefore, no complex pathways are required thereby anyhow providing a very efficient thermal management.

According to a further embodiment, the first outer layer comprises at least one, advantageously a plurality of channels proceeding from an outer portion of the first outer layer in the plane of the first outer layer to an inner portion of the first outer layer in the plane of the first outer layer for connecting the at least one inlet fluid flow path and the at least one outlet fluid flow path. This may be especially advantageous in case the channels proceed at least partly in the plane of the outer layer. Again, this arrangement may be especially preferred in case both of the first outer layer and the second outer layer are respectively formed. This embodiment may again provide a large area in the plane of the outer layer which thermally interacts with the cooling fluid. This in turn allows an especially effective thermal management. The respective channels may be formed straight and aligned to a center region, which may be formed by the outlet fluid flow path. This may allow allows an especially easy manufacturing, which, however, is in no way limiting the scope of the present invention. However, the channels may alternatively for example be curved.

According to a further embodiment, a plurality of channels of the first outer layer proceeding from an outer portion of the first outer layer to an inner portion of the first outer layer in the plane of the first outer layer for connecting the at least one inlet fluid flow path and the at least one outlet fluid flow path are connected to each other by a plurality of secondary channels proceeding oblique to at least one of the plurality of channels. With this regard, the secondary channels as well proceed in the plane of the outer layer and are aligned oblique and thus such, that an angle a between at least one channel and one secondary channel has a value of less than 90°, preferably in a range of ≥ 20°to ≤ 70° preferably in a range of ≥ 35°to ≤ 55°, such as 45° in the flow direction of the cooling fluid. Especially in case a plurality of more than three channels are respectively connected, it may be provided that secondary channels proceeding from one side with regard to the flow direction are aligned in the afore-named angles, whereas secondary channels which are located at the opposite sides of the channel with regard to the flow direction of the cooling fluid are aligned in angles b having a value of more than 90°, preferably in a range of ≥ 110°to ≤ 150° preferably in a range of ≥ 125°to ≤ 145°, such as 135° in the flow direction of the cooling fluid with regard to the adjacent channel. Such an arrangement may thus particularly result in the formation of oblique fins.

According to this embodiment, it may be provided that the effectivity of the thermal management may further be improved. In fact, due to the secondary channels, improved mixing of the cooling fluid may be achieved which improves the homogeneity of the cooling effect, or heating effect, respectively. Apart from that, a pressure recovery effect may also be noticed which further enhances the heat transfer. Furthermore, the surface area for a heat transfer between the cooling liquid and the outer layer may be enlarged, further improving the effectiveness of thermal management. The above advantages may thereby be realized without complex manufacturing processes.

According to a further embodiment, at least one of the first outer layer and the second outer layer is formed from copper or from aluminium. Advantageously, both of the first outer layer and the second outer layer are formed from copper or from aluminium. According to this embodiment, on the one hand, these layers have a very large heat flux allowing an especially effective thermal management. On the other hand, power semiconductor devices or arrangements comprising these devices may be fixated to that layer especially easily, allowing forming a power semiconductor module especially easily.

Alternatively or additionally at least one of or advantageously all of the center layer, the first intermediate layer and the second intermediate layer may be formed from an electrically insulating material. Such a material preferably has a dielectric strength of at least 20kV/mm, particularly following the standards of at least one of DIN EN 60672, ASTM D149, DIN EN 60243 and DIN EN 60243.

For example, at least one of or advantageously all of the center layer, the first intermediate layer and the second intermediate layer may be formed from a ceramic material, or the respective one or more layers may be formed from an organic such as a polymeric material. Examples for ceramic materials comprise in a non-limiting manner alumina, whereas examples for polymeric materials comprise in a non-limiting manner resin based materials and/or epoxy-based materials such as the one being known under its name FR-4, which is a composite material composed of woven fiberglass cloth with an epoxy resin binder, and thus for example PCB-materials. Especially these materials may allow an easy manufacturing process combined with a high stability and further low material costs. Further, these materials allow advantageous implementing the cooling element into a power semiconductor module.

For example, at least one of the center layer, the first intermediate layer and the second intermediate layer which is formed from an electrically insulative material may be part of a printed circuit board (PCB). With this regard, it may be especially advantageous that at least one of the center layer, the first intermediate layer and the second intermediate layer which is formed from an electrically insulating material may be formed from a polymeric material and particularly of the above-named base materials for printed circuit boards (PCB materials). According to this embodiment, a highly integrated module may be realized, wherein the substrate on which the power semiconductor devices are located comprises a printed circuit board. Such an embodiment may use embedding technologies and processes generally known for printed circuit boards. The respective pathways for the cooling fluid like described above may be realized, for example, by means of contemporary drilling and routing techniques. Such modules may have the advantage of being especially flat and thus require only limited volume. Apart from that, an improved switching behaviour may be realized together with improved thermal management due to an improved thermal resistance in case the module comprises a PCB-based substrate.

According to a further embodiment, at least one outer layer which is formed from copper is part of a direct-bonded copper substrate (DBC substrate).

Alternatively or additionally, at least one outer layer which is formed from aluminium is part of an active metal brazed substrate (AMD substrate).

Such substrates generally comprise a ceramic main body, such as formed from alumina, which comprises a copper layer (DBC substrate) or aluminium (AMD substrate) as metallization bonded to one or both sides of the main layer for example by means of a high-temperature oxidation process or by a brazing process. The general setup of these substrates is known in the art.

These embodiments allow an especially easy and cost-saving formation of a power semiconductor module and a high integration of the temperature controlling element in said power semiconductor module as the conventional substrate on which power devices are located can be part of the temperature controlling element. Apart from that, the thermal contact between the temperature controlling element and the power semiconductor devices is especially close so that thermal management may be especially effective. Furthermore, this embodiment allows in an especially easy manner to scale the module up in a very high voltage class or, in other words, to form module which has an especially high performance.

Regarding further technical features and advantages of the temperature controlling element as described, it is referred to the description of the power semiconductor module, the figures and the description of the figures, and vice versa.

The present invention further relates to a power semiconductor module. Such a power semiconductor module comprises at least one power semiconductor device and at least one temperature controlling element like it is described in detail above for controlling the temperature of at least one power semiconductor device.

The at least one power semiconductor device such as the plurality of power semiconductor devices may be arranged as it is generally known in the art and may thus comprise active devices, such as a transistor, such as a switch, and/or a diode, or it may comprise passive devices, such as a capacitor, a filter, or an inductive element, for example. Such a power semiconductor device or advantageously, a plurality of such power semiconductor devices is cooled or heated by a temperature controlling element like described before. It may thereby be provided that either only active devices, only passive devices, or a combination of active and passive devices are located on a cooling element such as on one cooling element.

To summarize, a power semiconductor module as described provides a highly integrated temperature controlling element which permits targeted cooling of a plurality of power electronic components - primarily semiconductor chips - in an ultra-compact module in order to achieve very high heat transfer coefficients. Therefore, an especially effective thermal management of the power semiconductor module may be combined with low spatial requirements and an easy manufacturing process.

It may be especially preferred that the power semiconductor module comprises at least two power semiconductor devices, wherein at least one power semiconductor device is located adjacent to the first outer layer and wherein at least one power semiconductor device is located adjacent to the second outer layer. With this regard, it may be provided that at least one power semiconductor device is located at each side of the temperature controlling element and thus at least two power semiconductor devices are positioned at opposite sides, regarding the plane of the layers, of the temperature controlling element. A location adjacent to the respective outer layer shall thereby mean an arrangement at which the respective power semiconductor device is arranged for being cooled, or heated, respectively, from the respective outer layer.

This embodiment allows the temperature controlling element to have an especially high integration in the power semiconductor module. This in turn allows an especially large number of power semiconductor devices to be cooled or heated simultaneously, thereby controlling the respective temperatures very homogeneously and thus preferably essentially identically.

The temperature controlling element may thus act as a substrate or may be part of a substrate for an upper arrangement of power semiconductor devices as well as for a lower arrangement of power semiconductor devices. With this regard, the outer layers of the temperature controlling element may each be formed as a part of a substrate, such as a direct bonded copper substrate (DBC substrate), an active metal brazed substrate (AMB substrate), or the like. This allows an especially easy and further an especially compact structure having low spatial requirements.

In detail, the DBC substrate or the AMD substrate may be formed such that the metallization may form the outer layers and the ceramic part may form the center layer and the intermediate layers. The pathways for the cooling fluid may be introduced, for example, by drilling techniques like described above.

According to a further embodiment, it may be provided that at least one power semiconductor device is based on a wide bandgap semiconductor. Especially, it may be provided that a plurality or all power semiconductor devices are provided based on wide bandgap semiconductors.

Especially with regard to wide bandgap semiconductors, the thermal management is an important feature. Therefore, the power semiconductor module as described above is especially advantageous for such wide bandgap semiconductors being present in the power semiconductor devices such as in power semiconductor transistors.

In fact, small size of semiconductor devices is very typical for wide bandgap-devices in order to reach reasonable yield and costs. It means it is necessary to place from three to five times more chips into the module to achieve the same current rating as in silicon based modules, for example. Assuming the same size of the modules and same number of substrates in the module, one must place and connect three to five times more chips on one substrate in wide bandgap power modules. This fact is making power module design with good thermal management of silicon based modules, for example. According to the present invention, however, this may be realized without significant problems due to the effective cooling or heating behaviour.

Such semiconductor devices are based for example on silicon carbide (SiC) or gallium nitride (GaN). As an explanation but without being limited thereto, "wide" bandgap semiconductors typically refer to a material with a band gap of at least three eV. Such a band gap is significantly greater than these of the commonly used semiconductors, such as silicon (1.1 eV) or gallium arsenide (1.4 eV).

### Brief description of drawings

Additional features, characteristics and advantages of the subject-matter of the invention are disclosed in the sub claims, the figures and the following description of the respective figures and examples, which -in an exemplary fashion- show one embodiment and example of a cooling element for a power semiconductor module according to the invention.

In the figures:
Figure 1 shows a schematic exploded view of a cooling element for a power semiconductor module according to the invention comprising five layers;
Figure 2 shows an embodiment of the arrangement of channels in an outer layer and
Figure 3 shows the alignment of different channels of an outer layer according to figure 2.

### Description of embodiments

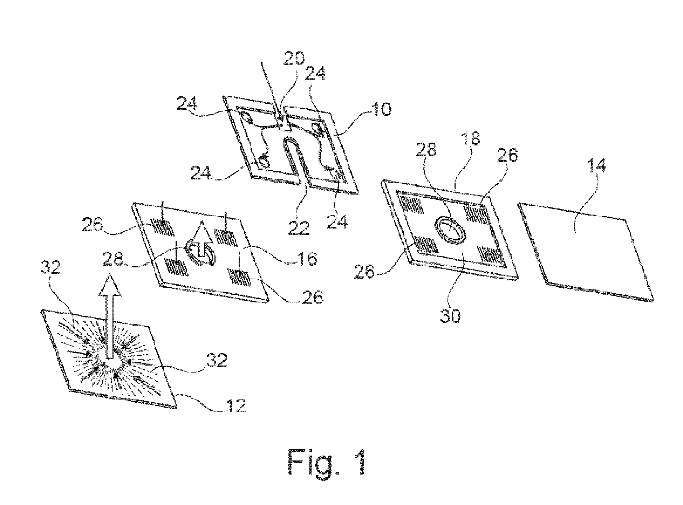

Figure 1 shows a layer arrangement comprising different layers for forming a cooling element formed as a double-sided jet cooler for a power semiconductor module.

In fact, figure shows a center layer 10, a first outer layer 12 and a second outer layer 14 each being arranged in a direction normal to the center layer 10, wherein the first outer layer 12 and the second outer layer 14 are located at opposite sides of the center layer 10. Further, a first intermediate layer 16 and a second intermediate layer 18 are shown, wherein the first intermediate layer 16 is located between the center layer 10 and the first outer layer 12 in a direction normal to the center layer 10, and wherein the second intermediate 18 layer is located between the center layer 10 and the second outer layer 14 in a direction normal to the center layer. These layers may be connected to each other to form a compact cooling element particularly in a sequence first outer layer 12, first intermediate layer 16, center layer 10, second intermediate layer 18, second outer layer 14, like it ca be seen from figure 1.

At least one of the center layer 10, the first intermediate layer 16 and the second intermediate layer 18 may be formed from an electrically insulating material such as a ceramic material, such as alumina, or such as a polymeric material. Additionally or alternatively, at least one of the first outer layer 12 and the second outer layer 14 may be formed from copper or aluminium. Especially in the latter case, at least one outer layer 12, 14 which is formed from copper may be part of a direct-bonded copper substrate and/or at least one outer layer 12, 14 which is formed from aluminium may be part of an active metal brazed substrate. The cooling element may thus form an interposing substrate comprising a jet cooling arrangement for direct power electronics for cooling stacked power electronic chips.

Referring to the center layer 10, the center layer 10 comprises an inlet 20 for guiding cooling fluid into the layer arrangement and an outlet 22 for guiding cooling fluid out of the layer arrangement. The inlet 20 and the outlet 22 are both in the plane of the center layer 10 and are thus formed co-planar. The center layer 10 is further adapted for guiding cooling fluid from the inlet 20 into the first intermediate layer 16 and into the second intermediate layer 18 and back from the first intermediate layer 16 and from the second intermediate 18 layer to the outlet 22. Therefore, fluid pathways may be provided which distribute the cooling fluid to different places of the center layer, such as in a direction in the plane of the center layer 10. According to figure 1, and in no way limiting amount of four areas are used comprising holes 24 for guiding the cooling fluid to the intermediate layers 16, 18.

The first intermediate layer 16 is adapted for guiding cooling fluid from the center layer 10 to the first outer layer 12 and the second intermediate layer 18 is adapted for guiding cooling fluid from the center layer 10 to the second outer layer 14. Further, the first outer layer 12 is adapted for guiding cooling fluid from the first intermediate layer 16 back to the first intermediate layer 16 and the second outer layer 14 is adapted for guiding cooling fluid from the second intermediate layer 18 back to the second intermediate layer 18.

In order to achieve the above, in the non-limiting embodiment of figure 1, the first intermediate layer 16 comprises a plurality of inlet fluid flow paths 26 being formed as orifices, or jets, respectively, for guiding cooling fluid from the center layer 10 to the first outer layer 12 and one outlet fluid flow path 28 for guiding cooling fluid from the first outer layer 12 to the center layer 10. The second intermediate layer 18 is respectively arranged even though this is not shown in detail. It may be provided that the first intermediate layer 16 as well as the second intermediate layer 18 is directed touching the first outer layer 12 or the second outer layer 14, respectively, fully, except the orifices like described below, or a free volume 30 may be provided between at least a part of the intermediate layer 16, 18 and the outer layer 12, 14. The free volume 30 may serve to homogenise the cooing fluid, it is however in no way mandatory. In the latter case, the free volume should be closed against the outside and the outlet fluid flow path 28 as described below.

Regarding the plurality of inlet fluid flow paths 26, these flow paths are positioned at an outer portion of the first intermediate layer 16 in the plane of the first intermediate layer 16 and the outlet fluid flow path 28 is provided being located at an inner portion of the first intermediate layer 26. The second intermediate layer 18 is arranged correspondingly.

Regarding the first outer layer 12, the latter is adapted for guiding cooling fluid from the inlet fluid flow paths 26 to the outlet fluid flow path 28. Further, the second outer layer 14 is adapted for guiding cooling fluid from the inlet fluid flow paths 26 to the outlet fluid flow path 28. With this regard, the first outer layer 12 comprises a plurality of channels 32 proceeding from an outer portion of the first outer layer 12 to an inner portion of the first outer layer 12 in the plane of the first outer layer 12 for connecting the inlet fluid flow paths 26 with the outlet fluid flow path 28. The second outer layer 14 is arranged correspondingly.

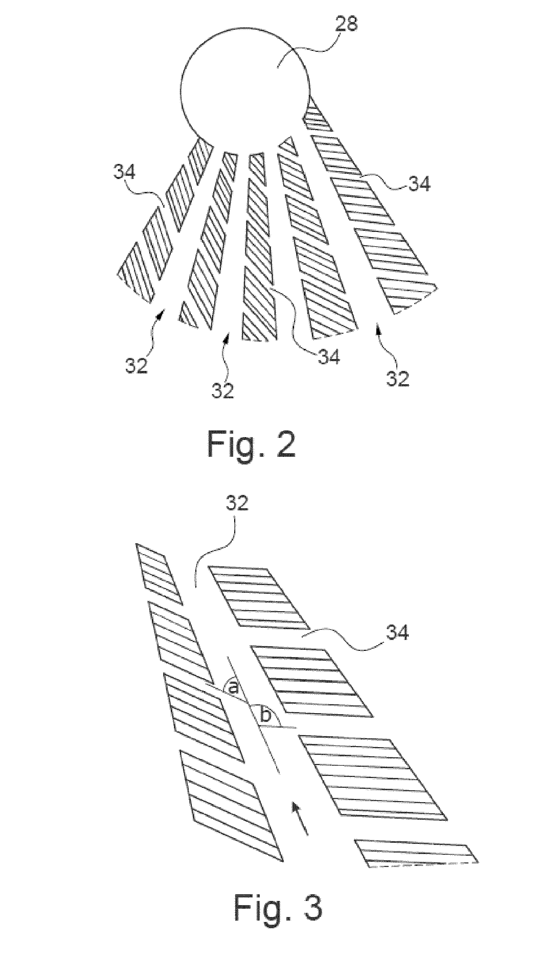

Figures 2 and 3 schematically show a part of an arrangement at which a plurality of channels 32 of the first outer layer 12 proceeding from an outer portion of the first outer layer 12 to an inner portion of the first outer layer 12 in the plane of the first outer layer 12 for connecting the inlet fluid flow paths 26 and the outlet fluid flow path 28 are connected to each other by secondary channels 34 proceeding oblique to at least one of the plurality of channels 32. The second outer layer 14 may be formed correspondingly.

As it can be seen from figure 2, the channels 32 each have a decreasing diameter in the flow direction of the cooling fluid and thus in the direction to the outlet fluid flow path 28. In other words, the channels 32 are converging. This may improve or allow the acceleration of the cooling fluid and will thus allow the channels 34 to act as a nozzle for providing a jet stream of the cooling fluid.

Further, it can be seen that the secondary channels 34 have a smaller diameter compared to the channels 32, for example, in case the diameter or its gradient of all channels 32 is the same and the diameter of all channels 34 is the same. In fact, the diameter of the secondary channels 34 may be smaller compared to the smallest diameter of the channels 32, or as the respective average diameter. This may allow the main channels 32 to carry the main portion of the cooling fluid.

It can be seen in figure 3 that a first secondary channel 34 is arranged in that it has an angle a between at least one channel 32 and the secondary channel 34 of less than 90°, preferably in a range of ≥ 20°to ≤ 80° preferably in a range of ≥ 35°to ≤ 55°, such as 45° in the flow direction of the cooling fluid. A second secondary channel 34 which is located at the opposite side compared to the first secondary channel 34 with regard to the flow direction of the cooling fluid is aligned in angle b to the channel 32 having a value of more than 90°, preferably in a range of ≥ 110°to ≤ 150° preferably in a range of ≥ 125°to ≤ 145°, such as 135° in the flow direction of the cooling fluid.

Especially such an arrangement may allow that the outer layer collect cooling fluid with minimal pressure drop and boundary layer development.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- 10: center layer
- 12: first outer layer
- 14: second outer layer
- 16: first intermediate layer
- 18: second intermediate layer
- 20: inlet
- 22: outlet
- 24: hole
- 26: inlet fluid flow path
- 28: outlet fluid flow path
- 30: free volume
- 32: channel
- 34: secondary channel

## Claims

1. Temperature controlling element for controlling the temperature of a plurality of power semiconductor devices in a power semiconductor module, the temperature controlling element comprising a layer arrangement with a plurality of layers, wherein the layer arrangement comprises
- a center layer (10),
- a first outer layer (12) and a second outer layer (14) each being arranged in a direction normal to the center layer (10), wherein the first outer layer (12) and the second outer layer (14) are located at opposite sides of the center layer (10) in a direction normal to the center layer (10), and
- a first intermediate layer (16) and a second intermediate layer (18), wherein the first intermediate layer (16) is located between the center layer (10) and the first outer layer (12) in a direction normal to the center layer (10), and wherein the second intermediate layer (18) is located between the center layer (10) and the second outer layer (14) in a direction normal to the center layer (10);
wherein
- the center layer (10) comprises an inlet (20) for guiding cooling fluid into the layer arrangement and an outlet (22) for guiding cooling fluid out of the layer arrangement, wherein the center layer (10) is further adapted for guiding cooling fluid from the inlet (20) into the first intermediate layer (16) and into the second intermediate layer (18) and back from the first intermediate layer (16) and from the second intermediate layer (18) to the outlet (22), wherein
- the first intermediate layer (16) is adapted for guiding cooling fluid from the center layer (10) to the first outer layer (12) and wherein the second intermediate layer (18) is adapted for guiding cooling fluid from the center layer (10) to the second outer layer (14), and wherein
- the first outer layer (12) is adapted for guiding cooling fluid from the first intermediate layer (16) back to the first intermediate layer (16) and wherein the second outer layer (14) is adapted for guiding cooling fluid from the second intermediate layer (18) back to the second intermediate layer (18).

2. Temperature controlling element according to claim 1, wherein the first intermediate layer (16) comprises at least one inlet fluid flow path (26) for guiding cooling fluid from the center layer (10) to the first outer layer (12) and at least one outlet fluid flow path (28) for guiding cooling fluid from the first outer layer (12) to the center layer (10), wherein the first outer layer (12) is adapted for guiding cooling fluid from the at least one inlet fluid flow path (26) to the at least one outlet fluid flow path (28).

3. Temperature controlling element according to claim 2, wherein at least one inlet fluid flow path (26) is provided being positioned at an outer portion of the first intermediate layer (16) in the plane of the first intermediate layer (16) and wherein at least one outlet fluid flow path (28) is provided being located at an inner portion of the first intermediate layer (16) in the plane of the first intermediate layer (16).

4. Temperature controlling element according to claim 3, wherein the first outer layer (12) comprises at least one channel (32) proceeding from an outer portion of the first outer layer (12) in the plane of the first outer layer (12) to an inner portion of the first outer layer (12) in the plane of the first outer layer (12) for connecting the at least one inlet fluid flow path (26) with the at least one outlet fluid flow path (28).

5. Temperature controlling element according to claim 4, wherein a plurality of channels (32) of the first outer layer (12) proceeding from an outer portion of the first outer layer (12) in the plane of the first outer layer (12) to an inner portion of the first outer layer (12) in the plane of the first outer layer (12) for connecting the at least one inlet fluid flow path (26) and the at least one outlet fluid flow path (28) are connected to each other by a plurality of secondary channels (34) proceeding oblique to at least one of the plurality of channels (32).

6. Temperature controlling element according to any of the preceding claims, wherein at least one of the center layer (10), the first intermediate layer (16) and the second intermediate layer (18) is formed from an electrically insulating material.

7. Temperature controlling element according to claim 6, wherein at least one of the center layer (10), the first intermediate layer (16) and the second intermediate layer (18) which is formed from an electrically insulating material is part of a printed circuit board.

8. Temperature controlling element according to any of the preceding claims, wherein at least one of the first outer layer (12) and the second outer layer (14) is formed from copper or aluminium.

9. Temperature controlling element according to claim 8, wherein at least one outer layer (12, 14) which is formed from copper is part of a direct-bonded copper substrate.

10. Temperature controlling element according to claim 8 or 9, wherein at least one outer layer (12, 14) which is formed from aluminium is part of an active metal brazed substrate.

11. Power semiconductor module, comprising at least one power semiconductor device and at least one temperature controlling element according to any of the preceding claims for controlling the temperature of at least one power semiconductor device.

12. Power semiconductor module according to claim 11, wherein the power semiconductor module comprises at least two power semiconductor devices, wherein at least one power semiconductor device is located adjacent to the first outer layer (12) and wherein at least one power semiconductor device is located adjacent to the second outer layer (14).

13. Power semiconductor module according to claim 11 or 12, wherein at least one power semiconductor device is based on a wide bandgap semiconductor.

14. Power semiconductor module according to any of claims 11 to 13, wherein the power semiconductor device comprises an active device, a passive device or both an active and a passive device.
